(19) Europäisches Patentamt
European Patent Office
Office européen des brevets

(11) Veröffentlichungsnummer : **0 458 739 A2**

(12)

# EUROPÄISCHE PATENTANMELDUNG

(21) Anmeldenummer : **91810319.3**

(22) Anmeldetag : **26.04.91**

(51) Int. Cl.$^5$ : **C08L 61/34,** C08L 63/02, // (C08L61/34, 63:02)

(30) Priorität : **21.05.90 DE 4016296**

(43) Veröffentlichungstag der Anmeldung :
**27.11.91 Patentblatt 91/48**

(84) Benannte Vertragsstaaten :
**AT BE CH DE ES FR GB IT LI NL SE**

(71) Anmelder : **Gurit-Essex AG**
**CH-8807 Freienbach (CH)**

(72) Erfinder : **Schreiber, Herbert**
**Seeblick 3**
**CH-8832 Wollerau (CH)**
Erfinder : **Burkart, Günter, Dr.**
**Neuzaunstrasse 9**
**CH-8732 Rufi (CH)**
Erfinder : **Knaus, Bruno**
**Hänggiwiesstrasse 6**
**CH-8832 Wollerau (CH)**

(74) Vertreter : **Rottmann, Maximilian R.**
**c/o Rottmann, Zimmermann + Partner AG**
**Glattalstrasse 37**
**CH-8052 Zürich (CH)**

(54) **Zu schwerentflammbaren und hochtemperaturbeständigen Kunststoffen härtbares Harz und Verfahren zu dessen Herstellung.**

(57) Durch Härtung eines härtbaren Harzes, welches besteht aus einem Gemisch aus :
(a) einer Komponente, welche aus mindestens einer thermisch härtbaren 1-Oxa-3-aza-tetralin-Gruppen enthaltende Verbindung besteht ;
(b) einer Komponente, welche aus mindestens einem härtbaren halogenierten Epoxyharz besteht ; gegebenenfalls
(c) einer Komponente, welche aus mindestens einem härtbaren nichthalogenierten Epoxyharz besteht ; und gegebenenfalls
(d) einem Härtungsmittel für Epoxyharze ;
erhält man schwerentflammbare und/oder hochtemperaturbeständige Kunststoffe. Durch Temperung können die Glasübergangstemperatur wesentlich erhöht und die mechanischen Eigenschaften weiter verbessert werden.

Die erhaltenen Kunststoffe können Verwendung finden : als elektrische Isolierstoffe, insbesondere Leiterplatten ; im Flugzeugbau, auch für tragende Konstruktionen ; ferner überall, wo flammfeste Harze eingesetzt werden sollen.

EP 0 458 739 A2

Die Erfindung betrifft:

– ein zu schwerentflammbaren und/oder hochtemperaturbeständigen Kunststoffen härtbares Harz, wie es in den Ansprüchen 1 bis 14 umschrieben ist;

– ein Verfahren zur Herstellung solcher Kunststoffe, wie es in den Ansprüchen 15 bis 17 umschrieben ist, sowie

– die Verwendung der nach dem Verfahren nach den Ansprüchen 15 bis 17 hergestellten Kunststoffe, wie sie in den Ansprüchen 18 bis 22 umschrieben ist.

1-Oxa-3-aza-tetralin-Gruppen enthaltende Verbindungen und deren Vorpolymere (im folgenden zusammen kurz "Oxazenharze" genannt) sind z.B aus den Veröffentlichungen CH-A5-574 978, 579 113 und 606 169 bekannt.

Aus der EP-A1-0 356 379 ist ein zu schwerentflammbaren und hochtemperaturbeständigen Kunststoffen härtbares Harz bekannt. Dieses besteht mindestens teilweise aus einem Gemisch aus

(a) einer Harzkomponente, welche mindestens eine thermisch härtbare 1-Oxa-3-aza-tetralin-Gruppen enthaltende Verbindung enthält oder aus einer solchen besteht; und aus

(b) einem mit der Harzkomponente (a) nicht mischbaren Flammschutzmittel,

und enthält gegebenenfalls ausserdem noch mindestens eine härtbare Epoxyverbindung.

Durch Härtung dieser Harze lassen sich zwar schwerentflammbare und hochtemperaturbeständige Produkte herstellen, doch sind deren Eigenschaften für viele Anwendungen immer noch unzureichend. So werden durch die Zusatzstoffe (b) die mechanischen und die elektrischen Eigenschaften verschlechtert.

Aufgabe der vorliegenden Erfindung ist daher eine weitergehende Verbesserung des Brandverhaltens von Oxazenharzen ohne Verschlechterung der übrigen Eigenschaften.

Diese Aufgabe wird erfindungsgemäss gelöst durch ein zu schwerentflammbaren und/oder hochtemperaturbeständigen Kunststoffen härtbares Harz. Dieses ist gekennzeichnet durch einen Gehalt an einem Gemisch, welches besteht aus:

(a) einer Komponente, welche aus mindestens einer thermisch härtbaren 1-Oxa-3-aza-tetralin-Gruppen enthaltende Verbindung besteht;

(b) einer Komponente, welche aus mindestens einem härtbaren halogenierten Epoxyharz besteht; gegebenenfalls

(c) einer Komponente, welche aus mindestens einem härtbaren nichthalogenierten Epoxyharz besteht; und gegebenenfalls

(d) einem Härtungsmittel für Epoxyharze.

Die 1-Oxa-3-aza-tetralin-Gruppen enthaltenden Verbindungen der Komponente (a) werden z.B. aus Phenolen durch Umsetzung mit Formaldehyd und einem Amin erhalten, etwa gemäss der Gleichung A:

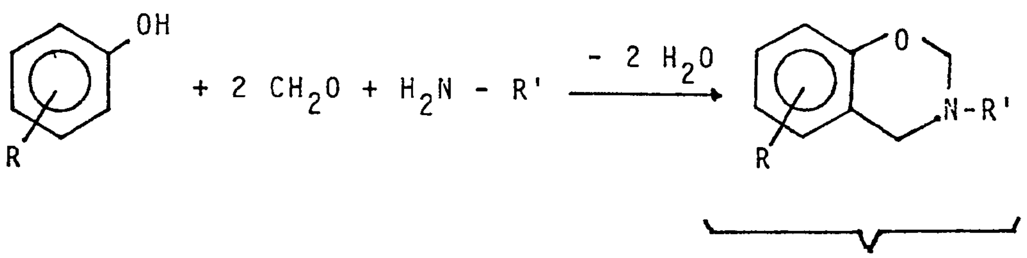


(A)

1-Oxa-3-aza-tetralin-Gruppe

R bedeutet beispielsweise Wasserstoff, Halogen, Alkyl oder Alkoxy. R' bedeutet einen aliphatischen oder aromatischen Rest.

Sie können aber auch nach anderen zu gleichartigen Produkten führenden Verfahren gewonnen werden.

Im Gegensatz zu anderen bekannten Kondensationsreaktionen von Phenolen, Aminen und Formaldehyd werden bei dieser Reaktion phenolische OH-Gruppen verbraucht. Aus der analytischen Bestimmung dieser Gruppen im Reaktionsgemisch lässt sich somit gemäss Gleichung A die Menge der synthetisierten 1-Oxa-3-aza-tetralin-Gruppen ermitteln.

Es können dabei auch Vorpolymere der 1-Oxa-3-aza-tetralin-Verbindungen eingesetzt werden. Da die 1-Oxa-3-aza-tetralin-Gruppen bei der Polymerisation wegreagieren, können diese Vorpolymere weniger 1-Oxa-3-aza-tetralin-Gruppen enthalten. Entscheidend ist auch hier, dass das intermediär gebildete oder hypothetische monomere Reaktionsprodukt 1-Oxa-3-aza-tetralin-Gruppen enthält. Dies ist für den Fachmann aus der Funktionalität leicht zu berechnen. Eine erfindungsgemäss einsetzbare 1-Oxa-3-aza-tetralin-Verbindung oder deren Vorpolymeres bildet sich z.B. dann, wenn sich die Molverhältnisse innerhalb der in der erwähnten Veröffentlichung CH-A5-606 169 definierten Grenze halten.

Als Ausgangs- bzw. Grundstoffe für die 1-Oxa-3-aza-tetralin-Verbindung dienen Phenol oder Phenol-Derivate sowie Amine und Formaldehyd.

Bevorzugt werden dabei als 1-Oxa-3-aza-tetralin-Gruppen enthaltende Verbindungen solche, die sich formell von einem Phenol und einem Amin ableiten, von denen die eine Komponente mehr als monofunktionell ist.

Beispiele geeigneter Phenole sind:

Einwertige Phenole, wie Phenol selbst, m- und p-Kresol, m- und p-Ethylphenol, m- und p-Isopropylphenol, m- und p-Isopropyloxyphenol, m- und p-Chlorphenol und beta-Naphthol. Dabei werden die para- oder meta-substituierten Phenole vorgezogen, weil bei ihnen keine reaktiven Stellen blockiert sind. Ferner werden vorgezogen die nicht alkyl- oder nicht alkyloxysubstituierten Phenole.

Zweiwertige Phenole, wie 4,4′-Dihydroxy-diphenylmethan, 3,3′-Dihydroxy-diphenylmethan, 2,2′-Bis-(4-hydroxyphenyl)-propan, 4,4′-Dihydroxy-stilben, Hydrochinon, Brenzkatechin und Resorcin.

Niedrig kondensierte Phenol-Formaldehyd-Novolak-Harze, gegebenenfalls auch als Mischungen mit Phenol.

Beispiele besonders geeigneter Amine sind:

Anilin, Phenylendiamin, Benzidin, Diaminodiphenyl-methan, 2,2′-Bis-(aminophenyl)-propan, Cyclohexylamin, Ethylendiamin und Propylendiamin, insbesondere p-Phenylendiamin und 4,4′-Diaminodiphenyl-methan. Aromatische Amine werden vorgezogen.

Geeignet sind insbesondere 1-Oxa-3-aza-tetralin-Verbindungen, welche sich von einem Novolak und einem aromatischen Amin, vorzugsweise von einem Novolak eines Polymerisationsgrades von ungefähr 2 und Anilin, oder sich von Phenol und einem aromatischen Diamin, ableiten.

Die zweite Komponente (b) enthält oder besteht zweckmässigerweise aus

– einem oder mehreren Glycidylethern von halogenierten Phenolen, insbesondere mehrwertigen Phenolen,

– einem oder mehreren Glycidylethern von Kondensationsprodukten von halogenierten Phenolen mit Aldehyden oder Ketonen, oder

– einem oder mehreren Glycidylethern von halogenierten Novolaken.

Besonders geeignet sind die Glycidylether von halogeniertem Bisphenol A oder halogeniertem Bisphenol F, insbesondere Tetrabrom-bisphenol A oder Tetrabrom-bisphenol F, sowie bromierte Novolake.

Vorzugsweise ist das halogenierte Epoxyharz der Komponente (b) ein bromiertes Epoxyharz.

Derartige bromierte Epoxyharze sind bekannt und im Handel erhältlich. Sie sind - für sich allein - auch bereits zur Herstellung von schwerentflammbaren Kunststoffen vorgeschlagen worden. Diese weisen jedoch verschiedene Nachteile auf:

– sie weisen tiefe Glasübergangstemperaturen auf;

– infolge ihres hohen Brom-Gehaltes erzeugen sie bei einem Brand erhebliche Mengen des hochgiftigen Carbonyldibromid;

– sie sind teuer.

Als Komponente (b) geeignete Handelsprodukte sind beispielsweise die folgenden bromierten Epoxyharze:

<u>Produkt Nr. 1</u> (Handelsname: "D.E.R. 511-A 80" der The Dow Chemical Company):

Bromiertes Epoxyharz vom Bisphenol-A-Typ in acetonischer Lösung.

| | | |
|---|---|---|
| Epoxidäquivalentgewicht [1)]: | 445...520 | |
| Viskosität (25°C): | 1000...4000 mPa's | |
| Nichtflüchtiges: | 80±1 | Gew.-% |
| Lösungsmittel: | Aceton | |
| Farbe nach Gardner, maximal: | 5 | |
| Bromgehalt [1)]: | 19...21 | Gew.-% |
| Flammpunkt (T.O.C.): | 63 | °C |

Produkt Nr. 2 (Handelsname: "D.E.R. 511-EK 80" der The Dow Chemical Company):

Bromiertes Epoxyharz vom Bisphenol-A-Typ in methylethylketonischer Lösung.

| | | |
|---|---|---|
| Epoxidäquivalentgewicht [1)]: | 445...522 | |
| Viskosität (25°C): | 1000...4000 | mPa·s |
| Nichtflüchtiges: | 80±1 | Gew.-% |
| Lösungsmittel: | Methylethylketon | |
| Farbe nach Gardner, maximal: | 9 | |
| Bromgehalt [1)]: | 19...21 | Gew.-% |
| Flammpunkt (T.O.C.): | 52 | °C |

Produkt Nr. 3 (Handelsname: "D.E.R. 512-A 80" der The Dow Chemical Company):

Bromiertes Epoxyharz vom Bisphenol-A-Typ in acetonischer Lösung.

| | | |
|---|---|---|
| Epoxidäquivalentgewicht [1)]: | 480...560 | |
| Viskosität (25°C): | 700...2500 | mPa·s |
| Nichtflüchtiges: | 80±1 | Gew.-% |
| Lösungsmittel: | Aceton | |
| Farbe nach Gardner, maximal: | 5 | |
| Bromgehalt [1)]: | 21...22,5 | Gew.-% |
| Flammpunkt (T.O.C.): | 56 | °C |

Produkt Nr. 4 (Handelsprodukt: "D.E.R. 512-EK 75" der The Dow Chemical Company):

Bromiertes Epoxyharz vom Bisphenol-A-Typ in methylethylketonischer Lösung.

| | | |
|---|---|---|
| Epoxidäquivalentgewicht [1)]: | 480...560 | |
| Viskosität (25°C): | 500...1500 | mPa·s |
| Nichtflüchtiges: | 75±1 | Gew.-% |
| Lösungsmittel: | Methylethylketon | |
| Farbe nach Gardner, maximal: | 3 | |
| Bromgehalt [1)]: | 21...22,5 | Gew.-% |
| Flammpunkt (T.O.C.): | <-2 | °C |

Produkt Nr. 5 (Handelsname: "D.E.R. 512-EK 80" der The Dow Chemical Company):

Bromiertes Epoxyharz vom Bisphenol-A-Typ in methylethylketonischer Lösung.

| | | |
|---|---|---|
| Epoxidäquivalentgewicht [1)]: | 480...560 | |
| Viskosität (25°C): | 1000...3500 | mPa·s |
| Nichtflüchtiges: | 80±1 | Gew.-% |
| Lösungsmittel: | Methylethylketon | |
| Farbe nach Gardner, maximal: | 5 | |
| Bromgehalt [1)]: | 21...22,5 | Gew.-% |
| Flammpunkt (T.O.C.): | 52 | °C |

Produkt Nr. 6 (Handelsname: "D.E.R. 521-A 80" der The Dow Chemical Company):

Bromiertes Epoxyharz vom Bisphenol-A-Typ in acetonischer Lösung.

| | | |
|---|---|---|
| Epoxidäquivalentgewicht [1)]: | 430...475 | |
| Viskosität (25°C): | 1000...4500 | mPa·s |
| Nichtflüchtiges: | 80±1 | Gew.-% |
| Lösungsmittel: | Aceton | |
| Farbe nach Gardner, maximal: | 6 | |
| Bromgehalt [1)]: | 19...22 | Gew.-% |
| Flammpunkt (T.O.C.): | 63 | °C |

Produkt Nr. 7 (Handelsname: "D.E.R. 542" der The Dow Chemical Company):

Bromiertes Epoxyharz vom Bisphenol-A-Typ.

| | | |
|---|---|---|
| Epoxidäquivalentgewicht [1)]: | 305...355 | |
| Erweichungpunkt nach Durran: | 50,5...62,5 | °C |
| Bromgehalt: | 44...49 | Gew.-% |
| Flammpunkt (T.O.C.): | 199 | °C |

Produkt Nr. 8 (Handelsname: "D.E.R. 566-A 80" der The Dow Chemical Company):

Bromiertes Epoxyharz vom Bisphenol-A-Typ in acetonischer Lösung.

| | | |
|---|---|---|
| Epoxidäquivalentgewicht [1]: | 410...450 | |
| Viskosität (25°C): | 800...4000 | mPa·s |
| Nichtflüchtiges: | 80±1 | Gew.-% |
| Lösungsmittel: | Aceton | |
| Farbe nach Gardner, maximal: | 5 | |
| Bromgehalt [1]: | 18...20 | Gew.-% |
| Flammpunkt (T.O.C.): | <2 | °C |

Produkt Nr. 9 (Handelsname: "QUATREX 6410" der The Dow Chemical Company):

Bromiertes Epoxyharz vom Bisphenol-A-Typ.

| | | |
|---|---|---|
| Epoxidäquivalentgewicht [1]: | 450 | |
| Erweichungpunkt: | 80 | °C |
| Viskosität (150°C): | 0,0180 | $m^2 \cdot s^{-1}$ |
| Hydrolysierbares Chlorid: | <150 | ppm |
| Flüchtiges: | <0,25 | Gew.-% |
| Bromgehalt: | 47...51 | Gew.-% |
| Glasumwandlungstemperatur nach phenolischer Härtung: | 175 | °C |

1) Bezogen auf den Feststoffgehalt

Der Halogen-Gehalt beträgt zweckmässig weniger als 3 Grammäquivalente, insbesondere weniger als 2 Grammäquivalente, bezogen auf 1 kg des Gesamtgewichtes der Komponenten nach Anspruch 1.

Dementsprechend beträgt bei Harzen, in welchen die Komponente (b) ein bromiertes Epoxyharz ist, der Brom-Gehalt zweckmässigerweise weniger als 24 Gew.-%, insbesondere weniger als 16 Gew.-%, bezogen auf das Gesamtgewicht des Harzes. Selbst mit weniger als 7,5, 2,5 oder 1 Gew.-% werden flammfeste Kunststoffe erhalten.

Zweckmässigerweise beträgt die Menge der Komponente (b) weniger als 50 Gew.-%, insbesondere weniger als 30 Gew.-%, bezogen auf das Gesamtgewicht der Harzes (Komponente (a) + Komponente (b)). Flammbeständige Harze werden aber auch schon mit weniger als 15 Gew.-%, weniger als 5 Gew.-%, oder sogar weniger als 2 Gew.-% der Komponente (b), bezogen auf das Gesamtgewicht der Harzes erhalten.

Die Tatsache, dass die im folgenden beschriebenen Vorteile sich mit derart geringen Mengen der Komponente (b), insbesondere bromiertem Epoxyharz, erzielt werden können, war für den Fachmann in hohem Masse überraschend.

Neben einem wesentlich verbesserten thermischen Verhalten in Kombination mit sehr guten elektrischen Eigenschaften, auf welche im folgenden noch im Detail eingegangen wird, ist von besonderem Vorteil, dass

bei einem Brand nur wenig Giftstoffe entstehen und dass nur wenig der teuren Komponente (b) eingesetzt werden muss.

Das erfindungsgemässe Gemisch kann ausserdem eine Komponente (c), welche mindestens ein härtbares nichthalogeniertes Epoxyharz enthält oder daraus besteht, enthalten. Zweckmässigerweise beträgt dabei die Menge dieser Komponente (c) weniger als die Menge der Komponente (b), vorzugsweise weniger als die Hälfte der Komponente (b).

Als derartige Epoxyharze eignen sich insbesondere mono- oder mehrfunktionelle, thermisch, katalytisch oder durch Härtersubstanzen härtbare Epoxyverbindungen.

Das erfindungsgemässe Gemisch kann ausserdem als Komponente (d) ein Härtungsmittel für Epoxyherze enthalten. Als solches eignen sich insbesondere mehrwertige Amine, mehrwertige Carbonsäuren und deren Anhydride, Dicyandiamid und Novolake.

Geeignete Epoxyverbindungen und Härtungsmittel sind z.B. beschrieben in:

- Sidney H. Goodman, Handbook of Thermoset Plastics, Noyes Publications, Park Ridge, NJ;
- W. G. Potter, Epoxide Resins, Ilife Books, London;
- Henry Lee und Kris Neville, Handbook of Epoxy Resins, McGraw-Hill Book Company, New York/San Francisco/Toronto/London.

Durch thermische Härtung der erwähnten härtbaren Harze bei Temperaturen über 100 °C, insbesondere 140 bis 220 °C, erhält man schwerentflammbare, hochtemperaturstabile und hitzestabile Kunststoffe.

Überraschenderweise können die so gehärteten Kunststoffe durch eine thermische Nachbehandlung in ihren Eigenschaften noch wesentlich verbessert werden. So erhöht sich z.B. die Glasübergangstemperatur durch 24stündiges Tempern bei 220 °C auf über 280 °C.

Zweckmässigerweise unterwirft man die gehärteten Kunststoffe dieser thermischen Nachbehandlung bei Temperaturen von 180 bis 250 °C, vorzugsweise bei 200 bis 230 °C. Die Dauer dieser Temperung richtet sich nach der Höhe der Temperatur. Folgende Richtwerte können als Anhaltspunkte dienen, wobei die Zeiten aber auch beliebig verlängert werden können, ohne dass die Kunststoffe geschädigt werden:

Härtung:
4 h bei 180 °C; oder
2 h bei 200 °C.
Temperung:
24 h bei 220 °C.

Diese Zeiten können auch beliebig anteilsmässig kombiniert werden. So hat sich z.B. folgender Temperungszyklus bewährt:

30 min/200°C + 30 min/220°C + 30 min/230°C + 30 min/250°C.

Die Eigenschaften der so hergestellten Kunststoffe können durch übliche Zusatzstoffe auf bestimmte Anwendungen zugeschnitten werden. Von Bedeutung sind insbesondere:

- Verstärkungsfasern, wie Glas-, Quarz-, Kohlenstoff-, mineralische und synthetische Fasern, und zwar in den üblichen Formen als Kurzfaser, Stapelfaser, Faden, Gewebe oder Matte;
- Weichmacher, insbesondere Phosphorverbindungen;
- Russ oder Graphit;
- Füllstoffe;
- Farbstoffe;
- Mikrohohlkugeln;
- Metallpulver;
- Katalysatoren; und
- Flammschutzmittel, insbesondere folgende Stoffgruppen bzw. Stoffe:
  Aluminiumhydroxid;
  hydratisiertes Calcium-Magnesium-Carbonat;
  Magnesiumhydroxid;
  elementarer roter Phosphor;
  Sauerstoffsäuren des Phosphors;
  anorganische Salze von Sauerstoffsäuren des Phosphors;
  organische Salze von Sauerstoffsäuren des Phosphors;
  Polyphoshate;
  Borsäure;
  Salze der Borsäure.

Für die Verarbeitung eignen sich die für wärmehärtbare Phenol-Formaldehyd-Harze oder EP-Harze bekannten Verfahren, wie z.B. Heisspressen von Prepregs, SMC (Sheet Molding Compound), oder Pressen von Pressmassen; Giessen; Faserwickelverfahren; Vakuum-imprägnierung.

Die durch Härten oder Härten und anschliessendes Tempern der erfindungsgemässen Harze, in unverstärkter oder verstärkter Form, erhältlichen schwerentflammbaren und hochtemperaturbeständigen Kunststoffe eignen sich namentlich für folgende Verwendungen:

- als elektrische Isolierstoffe, insbesondere Leiterplatten;
- für tragende Konstruktionen, insbesondere im Flugzeugbau;
- überall, wo flammfeste oder hochtemperaturbeständige Harze eingesetzt werden sollen;
- als Klebstoffe.

Ausführungsbeispiele

1. Ausgangsmaterialien

In den folgenden Beispielen werden folgende Ausgangsmaterialien verwendet:

Komponente (a):

(A/1) Oxazenharz 1

Umsetzungsprodukt von Phenol mit Anilin und Formaldehyd im Molverhältnis 1:1:2 der Strukturformel:

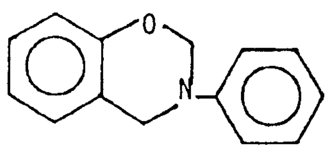

(A/2) Oxazenharz 2

Umsetzungsprodukt von 1 Mol (2 Äqu) des durch Umsetzung von 2 Mol Phenol und 1 Mol Formaldehyd erhaltenen Novolaks mit 2 Mol Anilin und 4 Mol Formaldehyd zu einem Produkt der mittleren Zusammensetzung:

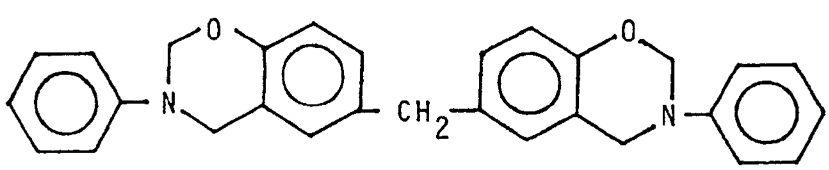

(A/3) Oxazenharz 3

Umsetzungsprodukt von 4,4'-Diamino-diphenylmethan mit Phenol und Formaldehyd im Molverhältnis 1:2:4 der Strukturformel:

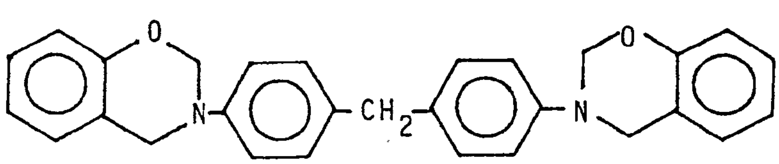

Komponente (b):

(B/1) Bromiertes Epoxyharz 1

"D.E.R 542" der The Dow Chemical Company (Produkt Nr. 7) Brom-Gehalt bezogen auf Feststoffe: 44...49 Gew.-%

(B/2) Bromiertes Epoxyharz 2

"Quatrex 6410" der The Dow Chemical Company (Produkt Nr. 9) Brom-Gehalt bezogen auf Feststoffe: 47...51 Gew.-%

Verstärkungsmittel

(V) Glasgewebe

"Typ 90085" der Interglas-Textil GmbH
Flächendichte: 108 g/m$^2$
Fadendichte/cm: 24x24
Epoxysilan-Finish

2. Probenherstellung

Die in Tabelle 1 angegebenen Komponenten wurden bei 100 - 130°C unter Vakuum gemischt. Dann wurden die Proben für die Thermo-analyse entnommen. Der Rest wurde, mit oder ohne Glasgewebe, zwischen teflonisierte Glasplatten eingesogen und 2 Stunden bei 200°C im Umluftofen gehärtet.
"Ref." bedeutet die intere Referenznummer der Anmelderin.

3. Flammfestigkeitsprüfung

Die Flammfestigkeitsprüfung erfolgte nach der UL-Vorschrift 94 (Vertikaltest), abgekürzt: "UL 94" (vgl.: Jürgen Troitzsch, Brandverhalten von Kunststoffen (1982 München/Wien ISBN 3-446-13391-7), 396...399).
Die Ergebnisse sind in Tabelle 1 zusammengestellt.
überraschend ist dabei, dass sich die Klasse UL-94-V0 bereits mit einem Zusatz von 20 Gew.-% bromiertem Epoxyharz, bei glasgewebeverstärkten Proben bereits mit einem solchen von 10 Gew.-% erreichen lässt.

4. Mechanische Eigenschaften

Die mechanischen Eigenschaften und die Glasübergangstemperatur $T_g$ (auch "Glastemperatur" genannt) wurden mit und ohne Temperung mittels
- DCS ("Differential Scanning Calorimetry"),
- DMA ("Differential Mechanical Analysis"), und
- TMA ("Thermo Mechanical Analysis")

ermittelt.
Die Ergebnisse sind in Tabelle 2 zusammengestellt.
In hohem Masse überraschend war die durch eine Temperung erzielbare Erhöhung der Glasübergangstemperatur bei einem wesentlich verminderter Abfall des E'-Moduls bei dieser Temperatur (vgl. insbesondere Probe 4 Ref. Kb71-G).

Tabelle 1: Zusammensetzung der Proben (Gew.-Teile) und Flammfestigkeitsprüfung nach UL 94

| Probe | <------------Zusammensetzung----------> | | | | | | <---Flammfestigkeit UL 94---> | | | | Ref. |
|---|---|---|---|---|---|---|---|---|---|---|---|
| Nr. | <------(a)------> | | | <--(b)---> | | Glas | Dicke | Brenndauer | | Ein- | |
| | A/1 | A/2 | A/3 | B/1 | B/2 | V | mm | s | | stu- | |
| | | | | | | Lagen | | 1. | 2. | fung | |
| | | | | | | | | Zündung | | | |
| 1 | | | 90 | 10 | | | 0,80 | 4,0 | 4,8 | V1 | Kb70 |
| 2 | | | 90 | 10 | | 9 | 0,92 | 2,8 | 3,0 | V0 | Kb70-G |
| 3 | | | 80 | 20 | | | 0,80 | 1,7 | 0,7 | V0 | Kb71 |
| 4 | | | 80 | 20 | | 9 | 0,90 | 1,5 | 0,5 | V0 | Kb71-G |
| 5 | | | 90 | | 10 | | 1,00 | 0,0 | 2,0 | V0 | 17-1 |
| 6 | | | 85 | | 15 | | 1,03 | 0,0 | 0,3 | V0 | 17-3 |
| 7 | | | 80 | | 20 | | 1,05 | 0,0 | 0,0 | V0 | 17-2 |
| 8 | | 90 | | | 10 | | 1,07 | 11,7 | 14 | V1 | 17-4 |
| 9 | | 85 | | | 15 | | 1,03 | 6,7 | 7,3 | V1 | 17-6 |
| 10 | | 80 | | | 20 | | 1,04 | 1,7 | 3,7 | V0 | 17-5 |
| 11 | | | 95 | | 5 | 9 | 1,04 | 10 | 3 | V1 | 17-9 |
| 12 | | | 97,5 | | 2,5 | 9 | 1,02 | 13 | 10 | V1 | 17-8 |
| 13 | | | 99 | | 1 | 9 | 1,02 | 38 | 10 | V1 | E1 |
| 14 | 80 | | | 20 | | | 1,00 | 3 | 2 | V0 | E2 |
| Vergleichsversuch | | | | | | | | | | | |
| -- | | | 100 | | | 9 | 1,02 | Brennt bis oben | | | 17-7 |

Tabelle 2: Mechanische Eigenschaften

| Probe | Härtung/ | <--------Festigkeit--------> | | | <-----DMA-------> | | TMA | DCS | Ref. |
|---|---|---|---|---|---|---|---|---|---|
| Nr. | Tempe- | Biege- | E-Modul | Dicke | 1) 2) | | 3) | 4) | |
| | rung | festigk. | | | $E'_{80°}$ | $E'_{180°}$ | $T_g$ | $T_g$ | |
| | h/°C | $N/mm^2$ | $N/mm^2$ | mm | GPa | GPa | °C | °C | |
| 1 | 2/200 | | | | 4,8 | 1,2 | 182 | 171 | Kb70 |
| 2 | 2/200 | 522±14 | 23'500 | 0,91 | 2,7 | 2,4 | | | Kb70-G |
| 3 | 2/200 | 118±5 | 11'800 | 0,85 | 5,8 | | 178 | | Kb71 |
| | +24/220 | 103±21 | 14'800 | | 5,7 | 4,9 | | | |
| | +72/220 | 112±29 | 14'400 | | 5,4 | 4,7 | | | |
| 4 | 2/200 | 495±14 | 22'300 | 0,91 | 3,0 | 1,6 | 178 | | Kb71-G |
| | + 2/220 | | | | 4,4 | 4,0 | | | |
| | +24/220 | | | | 8,5 | 8,2 | 280 | | |
| 5 | | | | | | | | 181 | 17-1 |
| 6 | | | | | | | | 179 | 17-3 |
| 7 | | | | | | | | 184 | 17-2 |
| 8 | | | | | | | | 162 | 17-4 |
| 9 | | | | | | | | 158 | 17-6 |
| 10 | | | | | | | | 156 | 17-5 |

Bemerkungen:

1) "Differential Mechanical Analysis"

2) Nur 1 Lage Glasfasern - d = 0,11...0,2 mm

3) "Thermo Mechanical Analysis"

4) "Differential Scanning Calorimetry"

**Patentansprüche**

1. Zu schwerentflammbaren und/oder hochtemperaturbeständigen Kunststoffen härtbares Harz, gekennzeichnet durch einen Gehalt an einem Gemisch, welches besteht aus:
   (a) einer Komponente, welche aus mindestens einer thermisch härtbaren 1-Oxa-3-aza-tetralin-Gruppen enthaltende Verbindung besteht;
   (b) einer Komponente, welche aus mindestens einem härtbaren halogenierten Epoxyharz besteht; gegebenenfalls
   (c) einer Komponente, welche aus mindestens einem härtbaren nichthalogenierten Epoxyharz besteht; und gegebenenfalls
   (d) einem Härtungsmittel für Epoxyharze.

2. Harz nach Anspruch 1, dadurch gekennzeichnet, dass die 1-Oxa-3-aza-tetralin-Verbindung der Komponente (a) sich von einer phenolischen Verbindung, Formaldehyd und einem Amin ableitet.

3. Harz nach Anspruch 1 oder 2, dadurch gekennzeichnet, dass die 1-Oxa-3-aza-tetralin-Verbindung der Komponente (a) sich formell von einer phenolischen Verbindung und einem Amin ableitet, von denen die eine Verbindung mehr als monofunktionell ist.

4. Harz nach einem oder mehreren der Ansprüche 1 bis 3, dadurch gekennzeichnet, dass die 1-Oxa-3-aza-tetralin-Verbindung der Komponente (a) sich von einem Novolak ableitet.

5. Harz nach Anspruch 4, dadurch gekennzeichnet, dass die 1-Oxa-3-aza-tetralin-Verbindung der Komponente (a) sich von einem Novolak eines Polymerisationsgrades von 1,5 bis 3 ableitet.

6. Harz nach einem oder mehreren der Ansprüche 1 bis 5, dadurch gekennzeichnet, dass die 1-Oxa-3-aza-tetralin-Verbindung der Komponente (a) sich von einem aromatischen Amin ableitet.

7. Harz nach einem oder mehreren der Ansprüche 1 bis 6, dadurch gekennzeichnet, dass die zweite Komponente (b) aus einen oder mehreren Glycidylether(n) von halogenierten Phenolen besteht.

8. Harz nach einem oder mehreren der Ansprüche 1 bis 6, dadurch gekennzeichnet, dass die Komponente (b) aus einen oder mehreren Glycidylether(n) von Kondensationsprodukten von halogenierten Phenolen mit Aldehyden oder Ketonen besteht.

9. Harz nach einem oder mehreren der Ansprüche 1 bis 8, dadurch gekennzeichnet, dass die Komponente (b) aus mindestens einem härtbaren bromierten Epoxyharz besteht.

10. Harz nach einem oder mehreren der Ansprüche 1 bis 9, dadurch gekennzeichnet, dass der Halogen-Gehalt weniger als 3 Grammäquivalente, insbesondere weniger als 2 Grammäquivalente, bezogen auf 1 kg des Gesamtgewichtes der Komponenten nach Anspruch 1, beträgt.

11. Harz nach einem oder mehreren der Ansprüche 1 bis 10, dadurch gekennzeichnet, dass die Menge der Komponente (b) weniger als 50 Gew.-%, insbesondere weniger als 30 Gew.-%, bezogen auf das Gesamtgewicht der Komponenten (a) und (b), beträgt.

12. Harz nach einem oder mehreren der Ansprüche 1 bis 11, dadurch gekennzeichnet, dass die Menge der Komponente (c) weniger als die Menge der Komponente (b) beträgt.

13. Harz nach einem oder mehreren der Ansprüche 1 bis 12, dadurch gekennzeichnet, dass es als Komponente (d) mehrwertige Amine, mehrwertige Carbonsäuren oder deren Anhydride, Dicyandiamid oder einen Novolak enthält.

14. Harz nach Anspruch 13, dadurch gekennzeichnet dass die Menge der Komponente (d) weniger als das 1,2-Fache der äquivalenten Gesamtmenge der Komponenten (a) und (b) beträgt.

15. Verfahren zur Herstellung von schwerentflammbaren und/oder hochtemperaturbeständigen Kunststoffen, dadurch gekennzeichnet, dass man ein Harz nach einem oder mehreren der Ansprüche 1 bis 14, in unverstärkter oder verstärkter Form, härtet oder härtet und anschliessend tempert.

**16.** Verfahren nach Anspruch 15, dadurch gekennzeichnet, dass man das Harz bei einer Temperatur von über 100°C härtet.

**17.** Verfahren nach Anspruch 15, dadurch gekennzeichnet, dass man das Harz bei einer Temperatur von 180 bis 250°C tempert.

**18.** Verwendung der nach dem Verfahren nach einem oder mehreren der Ansprüche 15 bis 17 hergestellten Kunststoffe als elektrische Isolierstoffe.

**19.** Verwendung der nach dem Verfahren nach einem oder mehreren der Ansprüche 15 bis 17 hergestellten Kunststoffe für tragende Konstruktionen.

**20.** Verwendung der nach dem Verfahren nach einem oder mehreren der Ansprüche 15 bis 17 hergestellten Kunststoffe als Klebstoffe.

**21.** Verwendung nach Anspruch 20 zum Verkleben von Metallen.

**22.** Verwendung nach Anspruch 20 zum Verkleben von Polyimidfolien.